# EUROPEAN PATENT SPECIFICATION

(11) **EP 2 660 263 B1**
(45) Date of publication and mention of the grant of the patent: **11.04.2018**
(21) Application number: 11854073.1
(22) Date of filing: 27.12.2011
(51) Int. Cl.: C08G 59/20, C08K 3/36, C08K 7/18, C08L 63/00, H01L 23/29, H01L 23/31

(54) **CURABLE EPOXY RESIN COMPOSITION**
HÄRTBARE EPOXIDHARZZUSAMMENSETZUNG
COMPOSITION DE RÉSINE ÉPOXY DURCISSABLE

(30) Priority: 27.12.2010 JP 2010289723
(43) Date of publication of application: 06.11.2013
(73) Proprietor: Dow Corning Toray Co., Ltd., Tokyo 100-0004 (JP)
(72) Inventor: MASATOMI, Toru, Ichihara-shi Chiba 299-0108 (JP); YOSHIZAWA, Takeshi, Ichihara-shi Chiba 299-0108 (JP); MORITA, Yoshitsugu, Ichihara-shi Chiba 299-0108 (JP); SASAKI, Motoshi, Ichihara-shi Chiba 299-0108 (JP)
(74) Representative: Murgitroyd & Company
(86) International application number: PCT/JP2011/080190
(87) International publication number: WO 2012/091000

(56) References cited:
- WO-A1-2008/078663
- JP-A- 1 020 226
- JP-A- 6 298 940
- JP-A- 7 310 017
- JP-A- H1 095 835
- JP-A- 10 095 835
- JP-A- H06 306 257

## Description

### [Technical Field]

The present invention relates to a curable epoxy resin composition having excellent fluidity during molding.

This application claims priority based on Japanese Patent Application No. 2010-289723 filed in Japan on December 27, 2010.

### [Background Art]

Flame-retardant curable epoxy resin compositions not containing halogens, phosphorous compounds, and heavy metals have hitherto been used for uses in electrical and electronic components. For example, flame-retardant curable epoxy resin compositions mixed with silica or other inorganic fillers have been used for uses in semiconductor sealants.

If the fluidity during molding of a curable epoxy resin composition is degraded, there is a possibility that it may lead to damage to a semiconductor or other electronic component during sealing of the electronic component, or it may not be possible to fill minute gaps in a mold during molding and it may become difficult to exhibit the function as a sealant, or some other such inconvenience may arise. Such inconveniences are notable, for example, when the quantity of inorganic filler mixed to further increase the flame retardancy of the curable epoxy resin composition is increased.

Meanwhile, organopolysiloxane resin, or the like, has been mixed in curable epoxy resin compositions for the purpose of suppression of thermal deformation, relaxation of internal stress, or the like (Patent Documents 1 to 6). However, with the conventional organopolysiloxane resin it was difficult to improve the fluidity during molding of the curable epoxy resin compositions, and accordingly it was difficult to increase the quantity of inorganic filler mixed in the composition.

### [Citation List]

### [Patent Literature]

Patent Document 1: Japanese Unexamined Patent Application Publication No. H6-298897
Patent Document 2: Japanese Unexamined Patent Application Publication No. H9-208806
Patent Document 3: Japanese Unexamined Patent Application Publication No. 2003-12767
Patent Document 4: Japanese Unexamined Patent Application Publication No. 2006-269730
Patent Document 5: Japanese Unexamined Patent Application Publication No. 2005-36085
Patent Document 6: Japanese Unexamined Patent Application Publication No. 2005-15559

JPH06306257 discloses a curable epoxy resin composition comprising an organosiloxane with phenyl groups and epoxy functional groups.

### [Summary of Invention]

### [Problem to be Solved by the Invention]

An object of the present invention is to provide a curable epoxy resin composition that exhibits excellent fluidity during molding without having adverse effects on the physical properties of the cured material.

### [Means for Solving the Problem]

The object of the present invention is achieved by a curable epoxy resin composition comprising: (I) a curable epoxy resin, and (II) an epoxy functional group- and aromatic hydrocarbon group-containing organopolysiloxane having an epoxy equivalent weight of 3,000 or lower, a content of aromatic hydrocarbon groups of 45 to 80% by weight (mass), and a glass transition point of less than 0°C.

The proportion of epoxy functional groups among organic groups bound to silicon atoms in a molecule of the organopolysiloxane is preferably 0.1 to 40 mol%.

The proportion of aromatic hydrocarbon groups among organic groups bound to silicon atoms in a molecule of the organopolysiloxane is preferably 40 mol% or higher.

The ingredient (II) is preferably a branched organopolysiloxane expressed by the following average unit formula:

(R¹R²R³SiO_{1/2})ₐ(R⁴R⁵SiO_{2/2})_{b}(R⁶SiO_{3/2})_{c} (1)

(wherein:
R¹, R², R³, R⁴, R⁵, and R⁶ respectively and independently represent a monovalent hydrocarbon group or an epoxy functional group, where at least one of R¹, R², R³, R⁴, R⁵, and R⁶ is an epoxy functional group, at least one of R¹, R², R³, R⁴, R⁵, and R⁶ is a monovalent aromatic hydrocarbon group; and
"a" is 0 to 0.2, "b" is a positive number, "c" is a positive number of 0.1 or higher, a + b + c = 1, and "3a + 2b + c" is in a range of 1.5 to 2.2).

The weight average molecular weight of the ingredient (II) is preferably 1,000 to 10,000.

The ingredient (I) is preferably a biphenyl group-containing epoxy resin.

The curable epoxy resin composition of the present invention preferably further contains (III) an epoxy resin curing agent.

The ingredient (III) is preferably a phenolic hydroxyl group-containing compound.

The phenolic hydroxyl group-containing compound is preferably a biphenyl group-containing phenolic resin.

The content of the ingredient (III) is preferably a quantity such that the epoxy reactive functional groups in the ingredient (III) are 0.5 to 2.5 moles per mole of epoxy groups in the ingredient (I).

The content of the ingredient (II) is preferably 0.1 to 100 parts by weight (mass) per 100 parts by weight (mass) of the ingredient (I) or of the total of the ingredients (I) and (III) .

The curable epoxy resin composition of the present invention preferably further contains (IV) an inorganic filler.

The inorganic filler is preferably spherical, and is more preferably spherical amorphous silica.

The content of the ingredient (IV) is preferably at least 20% by weight (mass) based on the total weight (mass) of the curable epoxy resin composition.

The curable epoxy resin composition of the present invention preferably further contains (V) an epoxy resin curing accelerator.

The content of the ingredient (V) is preferably 0.001 to 20 parts by weight (mass) per 100 parts by weight (mass) of the ingredient (I).

The curable epoxy resin composition of the present invention can be used favorably as a semiconductor sealant.

The present invention relates also to a cured material cured using the abovementioned curable epoxy resin composition.

### [Effects of the Invention]

The curable epoxy resin composition of the present invention can exhibit excellent fluidity during molding, and also can provide a cured material having physical properties at least equal to the linear expansion coefficient, flexural strength, flexural modulus, and other physical properties of cured materials cured using conventional curable epoxy resin compositions, without impairing the flame retardancy of the cured materials cured using conventional curable epoxy resin compositions.

Accordingly, the curable epoxy resin composition of the present invention can exhibit an excellent function as a sealant, because, for example, when used as a semiconductor sealant, the possibility of damage to the electronic component can be reduced, and minute gaps in molds can be filled during molding. Furthermore, the curable epoxy resin composition of the present invention can increase the flame retardancy of cured materials because a larger amount of inorganic filler can be mixed in.

In addition, when the curable epoxy resin composition of the present invention is liquid at 25°C, it can be used to fill fine spaces in semiconductor device junctions, glass fiber-reinforced circuit boards, or the like. Therefore, the curable epoxy resin composition of the present invention can exhibit a function not only as a liquid sealant, but also as an adhesive agent or an adhesion reinforcing material having excellent adhesiveness. Also, the curable epoxy resin composition of the present invention is a low stress composition and therefore can be expected to improve the reliability of electrical components.

### [Description of Embodiments]

The present inventor(s) discovered that the fluidity during molding of a curable epoxy resin composition containing a curable epoxy resin is improved when a specific organopolysiloxane is mixed into the composition. Thus, the curable epoxy resin composition of the present invention must contain (I) a curable epoxy resin, and (II) an epoxy functional group- and aromatic hydrocarbon group-containing organopolysiloxane having an epoxy equivalent weight of 3,000 or lower, a content of aromatic hydrocarbon groups of 45 to 80% by weight (mass), and a glass transition point of less than 0°C. Because the curable epoxy resin composition of the present invention has a low melt viscosity, more silica or other inorganic fillers can be mixed in than with conventional technology.

### (Curable epoxy resin)

The (I) curable epoxy resin (hereinafter referred to as "ingredient (I)") contained in the curable epoxy resin composition of the present invention is a main ingredient of the composition, and is not particularly limited provided that the epoxy resin has one or more glycidyl groups, cycloaliphatic epoxy groups, or other epoxy groups in a molecule, but an epoxy resin having two or more epoxy functional groups in a molecule is preferred. Examples of such ingredient (I) include novolac epoxy resins, cresol-novolac epoxy resins, triphenol alkane epoxy resins, aralkyl epoxy resins, biphenyl aralkyl epoxy resins, biphenyl epoxy resins, dicyclopentadiene epoxy resins, heterocyclic epoxy resins, naphthalene ring-containing epoxy resins, bisphenol A epoxy resins, bisphenol F epoxy resins, stilbene epoxy resins, trimethylolpropane epoxy resins, terpene modified epoxy resins, linear aliphatic epoxy resins obtained by oxidizing olefin bonds with peracetic acid, or other peracid, cycloaliphatic epoxy resins, and sulfur-containing epoxy resins. Two or more kinds of these epoxy resins may be combined as the ingredient (I). The ingredient (I) is particularly preferably a biphenyl aralkyl epoxy resin, biphenyl epoxy resin, or other biphenyl group-containing epoxy resin.

The ingredient (I) is generally available, and an example of a biphenyl epoxy resin is YX-4000 produced by Japan Epoxy Resin, an example of a bisphenol F epoxy resin is VSLV-80XY produced by Nippon Steel Chemical, an example of a biphenyl aralkyl epoxy resin is NC-3000 or CER-3000L (mixture with biphenyl epoxy resin) produced by Nippon Kayaku, and an example of a naphthol-aralkyl epoxy resin is ESN-175 produced by Nippon Steel Chemical. An example of a cycloaliphatic epoxy resin is Ceroxide 2021P produced by Daicel Chemical Industries.

Examples of curing mechanisms of these curable epoxy resins include thermosetting, UV curing, and moisture curing. Also, the ingredient (I) may be liquid at room temperature or solid having a softening point at room temperature or higher, but liquid at room temperature is particularly preferred. The obtained curable epoxy resin composition has better handling and working characteristics in the case when the ingredient (I) is liquid.

When the curable epoxy resin composition of the present invention is used as a semiconductor sealant/adhesive, the content of hydrolyzable chlorine in the ingredient (I) is preferably 1,000 ppm or lower, and particularly preferably 500 ppm or lower. Also, the contents of sodium and potassium in the ingredient (I) are preferably 10 ppm or lower of each. This is because there is a possibility that the moistureproofness of the sealed or adhered semiconductor under high temperature and high humidity may decrease when the content of hydrolyzable chlorine exceeds the upper limit of the abovementioned range or the content of sodium or potassium exceeds the upper limit of the abovementioned range.

### (Epoxy functional group- and aromatic hydrocarbon group-containing organopolysiloxane)

The (II) epoxy functional group- and aromatic hydrocarbon group-containing organopolysiloxane (hereinafter referred to as "ingredient (II)") contained in the curable epoxy resin composition of the present invention contains at least one epoxy functional group and at least one aromatic hydrocarbon group in a molecule. The epoxy functional group and/or aromatic hydrocarbon group is preferably bound to a silicon atom.

"Aromatic hydrocarbon group" in the present specification includes groups including only aromatic hydrocarbons, as well as groups having combined aromatic hydrocarbons and aliphatic saturated hydrocarbons. An example of a group having mixed aromatic hydrocarbons and saturated hydrocarbons is an aralkyl group. The aromatic hydrocarbon group is preferably a monovalent aromatic hydrocarbon. Monovalent aromatic hydrocarbon groups having 6 to 30 carbon atoms are preferred, and aryl groups and aralkyl groups are preferred.

The aryl groups are preferably C₆ to C₁₂ aryl groups, and examples include a phenyl group, naphthyl group, and tolyl group. A phenyl group is more preferred.

The aralkyl groups are preferably C₇ to C₁₂ aralkyl groups. Examples of C₇ to C₁₂ aralkyl groups include the benzyl group, phenethyl group, phenylpropyl group, and the like.

The monovalent aromatic hydrocarbon group may have a substituent, and examples of substituents include: a fluorine atom, chlorine atom, bromine atom, iodine atom, and other halogens; a hydroxyl group; methoxy group, ethoxy group, n-propoxy group, isopropoxy group, and other C₁ to C₆ alkoxy groups; an amino group; an amide group; a nitro group, and the like. The substituent can be bound to the hydrocarbon chain and to any site of the aromatic ring.

The epoxy equivalent weight of the ingredient (II) is 3,000 or lower. The epoxy equivalent weight in the present invention is measured by titration method, and preferably can be measured following JIS K 7236. When the epoxy equivalent weight is 3,000 or lower, preferably 2,000 or lower, and more preferably 1,500 or lower, exudation of other ingredients of the curable epoxy resin composition of the present invention onto the surface of the cured material cured using the composition thereof can be reduced or avoided, and contamination of the mold can be reduced or avoided.

The content of aromatic hydrocarbon groups in the ingredient (II) is 45 to 80% by weight (mass). When the content of aromatic hydrocarbon groups is 45 to 80% by weight (mass), preferably 45 to 70% by weight (mass), and more preferably 45 to 60% by weight (mass) of the ingredient (II), the fluidity during melting of the curable epoxy resin composition of the present invention can be improved.

The glass transition point of the ingredient (II) is less than 0°C. When the glass transition point is less than 0°C, preferably -10°C or lower, more preferably -20°C or lower, and even more preferably -30°C or lower, the handling characteristics of the curable epoxy resin composition of the present invention can be improved, and, for example, a spiral flow property can be improved.

The proportion of epoxy functional groups among organic groups bound to silicon atoms in a molecule of the ingredient (II) is preferably 0.1 to 40 mol%, more preferably 1 to 20 mol%, and even more preferably 2 to 15 mol%.

"Epoxy functional group" in the present invention signifies a group having at least one epoxy group. Specific examples of epoxy functional groups include a glycidyl group, glycidoxy group, 3,4-epoxybutyl group, 4,5-epoxypentyl group, epoxycyclohexyl group, 2-glycidoxyethyl group, 3-glycidoxypropyl group, 4-glycidoxybutyl group, 2-(3,4-ethoxycyclohexyl)ethyl group, 3-(3,4-epoxycyclohexyl)propyl group, and the like.

The proportion of aromatic hydrocarbon groups among organic groups bound to silicon groups in a molecule of the ingredient (II) is preferably 40 mol% or higher, more preferably 40 mol% to 60 mol%, and even more preferably 40 mol% to 50 mol%.

The ingredient (II) may contain a small quantity of silicon atom-bound hydroxyl groups or alkoxy groups. Examples of alkoxy groups include a methoxy group, ethoxy group, n-propoxy group, and isopropoxy group. In order to further reduce mold contamination, the quantity of silicon atom-bound hydroxyl groups or alkoxy groups present is preferably less than 10% by weight (mass) of the ingredient (II), more preferably less than 5% by weight (mass), and even more preferably less than 1% by weight (mass) of the ingredient (II).

The ingredient (II) is preferably a branched organopolysiloxane expressed by the following average unit formula:

(R¹R²R³SiO_{1/2})ₐ(R⁴R⁵SiO_{2/2})_{b}(R⁶SiO_{3/2})_{c} (1)

(wherein:
R¹, R², R³, R⁴, R⁵, and R⁶ respectively and independently represent a monovalent hydrocarbon group or an epoxy functional group, where at least one of R¹, R², R³, R⁴, R⁵, and R⁶ is an epoxy functional group, at least one of R¹, R², R³, R⁴, R⁵, and R⁶ is a monovalent aromatic hydrocarbon group; and
"a" is 0 to 0.2, "b" is a positive number, "c" is a positive number of 0.1 or higher, a + b + c = 1, and "3a + 2b + c" is in a range of 1.5 to 2.2).

Examples of monovalent hydrocarbon groups include monovalent saturated aliphatic hydrocarbon groups, monovalent unsaturated aliphatic hydrocarbon groups, and monovalent aromatic hydrocarbon groups.

The monovalent saturated aliphatic hydrocarbon groups are preferably those having 1 to 30 carbon atoms, and examples include: methyl group, ethyl group, n-propyl group, isopropyl group, n-butyl group, isobutyl group, sec-butyl group, tert-butyl group, pentyl group, hexyl group, heptyl group, octyl group, nonyl group, decyl group, and other linear or branched alkyl groups; and cyclopentyl group, cyclohexyl group, cycloheptyl group, cyclooctyl group, and other cycloalkyl groups. Methyl group is particularly preferred.

The monovalent unsaturated aliphatic hydrocarbon groups are preferably those having 2 to 30 carbon atoms, and examples include: vinyl group, 1-propenyl group, allyl group, isopropenyl group, 1-butenyl, 2-butenyl group, pentenyl group, hexenyl group, and other linear or branched alkenyl groups; cyclopentenyl group, cyclohexenyl group, and other cycloalkenyl groups; and cyclopentenylethyl group, cyclohexenylethyl group, cyclohexenylpropyl group, and other cycloalkenylalkyl groups. Alkenyl groups are preferred, and vinyl groups and hexenyl groups are particularly preferred.

The saturated hydrocarbon group may have a substituent, and examples of substituents include: fluorine atom, chlorine atom, bromine atom, iodine atom, and other halogens; hydroxyl group; methoxy group, ethoxy group, n-propoxy group, isopropoxy group, and other C₁ to C₆ alkoxy groups; amino groups; amide groups; nitro groups, and the like. The substituent can be bound to the hydrocarbon chain and to any site of the saturated ring.

The monovalent aromatic hydrocarbon group is as mentioned above.

The weight average molecular weight of the ingredient (II) is preferably 1,000 to 10,000, more preferably 1,000 to 5,000, and even more preferably 1,000 to 3,000. The viscosity (25°C) of the ingredient (II) is preferably 2,000 to 50,000 cP, and more preferably 5,000 to 20,000 cP.

In the average unit formula (1), "a" is preferably 0 in order to further reduce mold contamination. Also, "b" is preferably 0.25 or higher for improvement of handling characteristics, and "b" is preferably 0.8 or lower in order to further reduce mold contamination. Accordingly, "b" is preferably 0.25 to 0.80. Also, "c" is preferably 0.2 or higher in order to further reduce mold contamination, and "c" is preferably 0.6 or lower for improvement of handling characteristics. Accordingly, "c" is preferably 0.20 to 0.6. Furthermore, "3a + 2b + c" is preferably in a range of 1.6 to 2.1 for improvement of handling characteristics or in order to further reduce exudation of ingredients of the composition onto the surface of the cured material or to further reduce mold contamination.

The ingredient (II) can be synthesized for example, by reacting an epoxy group-containing alkoxysilane, a monovalent aromatic hydrocarbon group-containing alkoxysilane, and a hydrolysis/condensation product of a hydrolyzable group-containing organosilane in the presence of an alkaline polymerization catalyst. Examples of hydrolyzable groups include the previously stated C₁ to C₆ alkoxy groups. The alkaline polymerization catalyst is one that catalyzes the reaction of hydrolysis and condensation of the hydrolyzable groups and the reaction of equilibration of siloxane bonds. Examples include: sodium hydroxide, potassium hydroxide, cesium hydroxide, and other alkali metal hydroxides; calcium hydroxide, magnesium hydroxide, and other alkali earth metal hydroxides; sodium t-butoxide, potassium t-butoxide, cesium t-butoxide, and other alkali metal alkoxides; sodium silanolate compounds, potassium silanolate compounds, cesium silanolate compounds, and other alkali metal silanolate compounds. The alkaline polymerization catalyst preferably contains potassium or cesium. In addition, water is preferably added in order to facilitate the reactions of hydrolysis and condensation of the hydrolyzable groups. These reactions can be facilitated by heating, but the heating temperature is preferably in a range of 50 to 200°C, and more preferably 80 to 150°C. Also, this reaction can be carried out easily at a reflux temperature by selecting an organic solvent having a boiling point in a range of 50 to 200°C. It is common to add a polymerization catalyst neutralizing agent in order to stop the reaction and to remove the solid catalyst from the reaction system when the polymerization catalyst is a solid catalyst. The neutralizing agent is preferably carbon dioxide gas, acetic acid or other carboxylic acid, or other weak acids. The salt produced by neutralization can be removed by filtration or washing with water.

Examples of epoxy group-containing alkoxysilanes include 3-glycidoxypropyl (methyl) dimethoxysilane, 3-glycidoxypropyl (methyl) diethoxysilane, 3-glycidoxypropyl (methyl) dibutoxysilane, 2-(3,4-epoxycyclohexyl) ethyl (methyl) dimethoxysilane, 2-(3,4-epoxycyclohexyl) ethyl (phenyl) diethoxysilane, 2,3-epoxypropyl (methyl) dimethoxysilane, 2,3-epoxypropyl (phenyl) dimethoxysilane, 3-glycidoxypropyl trimethoxysilane, 3-glycidoxypropyl triethoxysilane, 3-glycidoxypropyl tributoxysilane, 2-(3,4-epoxycyclohexyl) ethyl trimethoxysilane, 2-(3,4-epoxycyclohexyl) ethyl triethoxysilane, 2,3-epoxypropyl trimethoxysilane, 2,3-epoxypropyl triethoxysilane, and the like.

Examples of monovalent aromatic hydrocarbon group-containing alkoxysilanes include phenyl trimethoxysilane, phenyl triethoxysilane, methylphenyl dimethoxysilane, diphenyl dimethoxysilane, methylphenyl diethoxysilane, diphenyl diethoxysilane, 2,4,6,8-tetramethyl-2,4,6,8-tetraphenyl cyclotetrasiloxane, and the like.

The content of the ingredient (II) in the curable epoxy resin composition of the present invention is not particularly limited, but is preferably 0.1 to 100 parts by weight (mass), more preferably 1 to 50 parts by weight (mass), and even more preferably 2 to 30 parts by weight (mass), per 100 parts by weight (mass) of the ingredient (I) or of the total of the ingredient (I) and an ingredient (III) to be described.

The curable epoxy resin composition of the present invention preferably further contains (III) an epoxy resin curing agent (hereinafter referred to as ingredient (III)"). The ingredient (III) is an epoxy resin curing agent for reacting with the epoxy groups in the ingredient (I) and curing the composition. The ingredient (III) is preferably a phenolic hydroxyl group-containing compound, and more preferably contains a biphenyl group. Examples of the ingredient (III) include phenol-novolac resins, naphthalene ring-containing phenolic resins, aralkyl phenolic resins, triphenolalkane phenolic resins, biphenyl phenolic resins, cycloaliphatic phenolic resins, heterocyclic phenolic resins, naphthalene ring-containing phenolic resins, bisphenol A, bisphenol F, and the like. Two or more kinds of these phenolic hydroxyl group-containing compounds may be combined as the ingredient (III). The ingredient (III) is particularly preferably a biphenylaralkyl phenolic resin or other biphenyl group-containing phenolic resin.

Also, the ingredient (III) may be a photocuring or UV curing agent. Examples of the ingredient (III) include aromatic diazonium salts, aromatic iodonium salts, aromatic sulfonium salts, aromatic metallocene compounds, and other cationic curing agents.

The ingredient (III) is generally available, and examples of aralkyl phenolic resins include Milex XLC-3L produced by Mitsui Chemical and MEH-781 produced by Meiwa Plastic Industries, an examples of naphthalene ring-containing phenolic resins include SN-475 and SN-170 produced by Nippon Steel Chemical, an example of a phenol-novolac resin is MEH-7500 produced by Meiwa Plastic Industries, and examples of biphenyl group-containing phenolic resins include MEH7851M and MEH 7851SS produced by Meiwa Plastic Industries.

The content of the ingredient (III) in the curable epoxy resin composition of the present invention is not particularly limited if it is the quantity which can cure the ingredient (I), but is preferably such that the epoxy reactive functional groups in the ingredient (III) are in a range of 0.5 to 2.5 moles per mole of epoxy groups in the ingredient (I). For example, when the ingredient (III) is a phenolic hydroxyl group-containing compound, the quantity is preferably such that the phenolic hydroxyl groups in the ingredient (III) are 0.5 to 2.5 moles per mole of epoxy groups in the ingredient (I). This is because curing of the composition tends to be insufficient when the content of the ingredient (III) is less than the lower limit of the abovementioned range, and because the strength of the cured material tends to decrease when the content exceeds the upper limit of the abovementioned range.

An (IV) inorganic filler (hereinafter referred to as "ingredient (IV)") may be further mixed as another optional ingredient into the curable epoxy resin composition of the present invention in order to give strength to the obtained cured material. Although the strength of the obtained cured material generally can be increased when an inorganic filler is mixed into the curable epoxy resin composition, there is a possibility that the fluidity of the composition may decrease significantly, and the moldability may be degraded, electronic components may be damaged, and it may be difficult to fill fine minute gaps in molds during molding. However, because the curable epoxy resin composition of the present invention contains the ingredient (II), it has excellent fluidity during molding and the moldability is not impaired. Accordingly, the curable epoxy resin composition of the present invention has excellent moldability and a high-strength cured material can be formed even though an inorganic filler is contained.

The ingredient (IV) usually is not particularly limited provided that the inorganic filler can be mixed into the curable epoxy resin composition of the present invention, and examples include: glass fiber, asbestos, alumina fiber, ceramic fiber containing alumina and silica as ingredients, boron fiber, zirconia fiber, silicon carbide fiber, metal fiber, and other fibrous fillers; and amorphous silica, crystalline silica, precipitated silica, fumed silica, sintered silica, zinc oxide, sintered clay, carbon black, glass beads, alumina, talc, calcium carbonate, clay, aluminum hydroxide, magnesium hydroxide, barium sulfate, titanium dioxide, aluminum nitride, boron nitride, silicon carbide, aluminum oxide, magnesium oxide, titanium oxide, beryllium oxide, kaolin, mica, zirconia, and other powdery fillers. Two or more kinds of these inorganic fillers may be combined as the ingredient (IV). Also, the shape of the ingredient (IV) is not limited, and examples include spherical, acicular, flat and broad, and fragment form (undefined form), but spherical form is preferred because the moldability is favorable. The ingredient (IV) is particularly preferably spherical amorphous silica. The mean particle size of the ingredient (IV) is not limited, but is preferably in a range of 0.1 to 50 µm because the moldability is favorable. Also, two or more kinds of inorganic fillers having different mean particle sizes may be combined as the ingredient (IV).

In addition, the surface of the ingredient (IV) may be treated in advance with a silane coupling agent, titanate coupling agent, or other coupling agent in order to improve the affinity with the ingredient (I). Examples of silane coupling agents include: 3-glycidoxypropyl trimethoxysilane, 3-glycidoxypropylmethyl diethoxysilane, 2-(3,4-epoxycyclohexyl) ethyl trimethoxysilane, and other epoxy group-containing alkoxysilanes; N-(2-aminoethyl)-3-aminopropyl trimethoxysilane, 3-aminopropyl triethoxysilane, N-phenyl-3-aminopropyl trimethoxysilane, and other amino group-containing alkoxysilanes; 3-mercaptopropyl trimethoxysilane and other mercapto group-containing alkoxysilanes; and additionally 3-isocyanate propyl triethoxysilane and 3-ureidopropyl triethoxysilane. Also, an example of a titanate coupling agent is i-propoxytitanium tri(i-isostearate). Two or more kinds of these coupling agents may be combined. The quantity mixed of the coupling agent used for surface treatment and the method of surface treatment are not limited.

The content of the ingredient (IV) of the curable epoxy resin composition of the present invention is not particularly limited, but the content is preferably at least 20% by weight (mass), more preferably at least 30% by weight (mass), even more preferably at least 50% by weight (mass), and particularly preferably at least 80% by weight (mass) of the curable epoxy resin composition of the present invention. This is because the strength of the obtained cured material tends to be insufficient when the content is less than the lower limit of the abovementioned range.

In the curable epoxy resin composition of the present invention, the ingredient (IV) may be thoroughly dispersed in the ingredient (I) and/or ingredient (II) as well as the ingredient (III) depending on the case, and a silane coupling agent, titanate coupling agent, or other coupling agent may be mixed into the curable epoxy resin composition of the present invention in order to improve the affinity with the ingredient (I) and/or ingredient (II) as well as the ingredient (III) and ingredient (IV). Examples of the coupling agents are the same as those previously mentioned.

The curable epoxy resin composition of the present invention may contain (V) an epoxy resin curing accelerator (hereinafter referred to as "ingredient (V)") as another ingredient. Specific examples of the ingredient (V) include: triphenyl phosphine, tributyl phosphine, tri(p-methylphenyl) phosphine, tri(nonylphenyl) phosphine, triphenyl phosphine-triphenyl borate, tetraphenyl phosphine-tetraphenyl borate, triphenyl phosphine-quinone adduct, and other phosphorous-based compounds; triethylamine, benzyl diethylamine, α-methylbenzyl dimethylamine, 1,8-diazabicyclo[5.4.0] undecene-7, and other tertiary amine compounds; and 2-methylimidazole, 2-phenylimidazole, 2-phenyl-4-methylimidazole, and other imidazole compounds.

The content of the ingredient (V) in the curable epoxy resin composition of the present invention is not particularly limited, but the content is preferably within a range of 0.001 to 20 parts by weight (mass) per 100 parts by weight (mass) of the ingredient (I). This is because the reaction between the ingredient (I) and the ingredient (III) tends to be less accelerated when the content of the ingredient (V) is less than the lower limit of the abovementioned range, and because the strength of the obtained cured material tends to decrease when the content exceeds the upper limit of the abovementioned range.

The curable epoxy resin composition of the present invention may contain as needed a thermoplastic resin, thermoplastic elastomer, organic synthetic rubber, silicone, or other stress reducers; carnauba wax, higher fatty acid, synthetic wax, or other wax; carbon black or other coloring agents; a halogen trapping agent, an ion trapping agent, or the like.

The method for preparation of the curable epoxy resin composition of the present invention is not particularly limited, but the curable epoxy resin composition is prepared by homogeneously mixing the ingredient (I) and ingredient (II) as well as the other optional ingredients. In the case when the ingredient (III) is used, the dispersibility of the ingredient (II) can be improved when the ingredient (II) is mixed into a composition in which the ingredient (I) and ingredient (III) were mixed in advance. Also, another example is a method in which the ingredient (I) and ingredient (IV) are mixed, and then the ingredient (II) and the other optional ingredients are homogeneously mixed. Other examples in this instance include a method in which a coupling agent is added to the ingredient (I) and ingredient (IV) to prepare an integral blend, and a method in which the ingredient (IV) is surface treated with a coupling agent in advance and is then mixed with the ingredient (I). Also, examples of apparatuses for preparing the curable epoxy resin composition of the present invention include a uniaxial or biaxial continuous mixer, double roll, Ross mixer, kneader mixer, Henschel mixer, and other mixing and agitating machines.

Because the curable epoxy resin composition of the present invention has excellent moldability, molding can be performed favorably by transfer molding, injection molding, or the like, and because the flame retardancy of the cured material is excellent, the curable epoxy resin composition is useful for application in electrical and electronic components. The curable epoxy resin composition of the present invention is particularly ideal as a semiconductor sealant.

The cured material of the present invention is cured by heating, or the like, of such curable epoxy resin compositions of the present invention. The cured material has excellent dimensional characteristics as a molded product even though the linear expansion coefficient, flexural strength, flexural modulus, and other physical properties are equal to or higher than conventional product, and is ideal as a matrix resin for electrical and electronic components, particularly for members having sealed or adhered semiconductor elements, and for circuit boards. Moreover, because the curable epoxy resin composition includes a larger amount of inorganic filler, it can exhibit more excellent performance in flame retardancy as well as physical strength than conventional compositions.

### [Examples]

The present invention is described in detail below based on Examples, but the present invention is not limited to the Examples. In the Examples, Ph represents a phenyl group, Me represents a methyl group, and Ep represents a 3-glycidoxypropyl group.

### (Viscosity)

Measurement was performed at 25°C using a Vismetron VG-A1 single cylinder-type rotary viscometer (produced by Shibaura System).

### (Weight average molecular weight)

The value is obtained through standard polystyrene conversion using gel permeation chromatography.

### (Glass transition point (Tg))

Measurement was performed using a differential calorimeter (DSC: SSC5200 produced by SII).

### (Structural analysis)

The structure of the organopolysiloxane was confirmed by ²⁹Si-nuclear magnetic resonance spectral analysis (JNM-ECA500 produced by NEC).

### (Epoxy equivalent weight)

Measurement was performed by a titration method based on JIS K-7236.

### (Melt viscosity)

Measurement was performed using a DV-III Thermosel-equipped Brookfield programmable rheometer with heating to 100°C.

### (Spiral flow)

Tests were performed 3 times using a mold for spiral flow measurements in accordance with EMMI-1-66 with a mold temperature of 175°C, a mold pressure of 70 kgf/cm², a plunger speed of 5 cm/s, a curing time of 180 seconds, and 15 g sample weight, and the mean value was calculated.

### (Linear expansion coefficient)

Measurement was performed by a thermomechanical analysis method (TMA). A 10×70×3 mm strip-shaped test piece was fabricated with molding conditions of 175°C mold temperature, 70 kgf/cm² mold pressure, 5 cm/s plunger speed, and 80 seconds curing time, and a 10×5×3 mm test piece was prepared by cutting from the above test piece, and was supplied for measurements. Measurements were performed with a temperature range of room temperature to 300°C, a rate of temperature increase of 5°C/min, a nitrogen atmosphere (50 ml/min), and a load of 20 mN.

### (Flexural strength and flexural modulus)

A 10×70×3 mm strip-shaped test piece was fabricated with molding conditions of 175°C mold temperature, 70 kgf/cm² mold pressure, 5 cm/s plunger speed, and 80 seconds curing time, and the test piece was measured.

### (Flame retardancy)

A 13×125×1.6 mm strip-shaped test piece was fabricated under the above molding conditions, and the test was based on the UL 94/V method.

### (Preparation of hydrolyzed condensed phenyltrichlorosilane)

An amount of 250 g of water and 400 g of toluene were put into a 2,000 ml flask equipped with a thermometer and a reflux cooling pipe, the solution was adjusted to 10°C, and a mixed solution of 300 g of phenyltrichlorosilane and 200 g of toluene was added dropwise. After dripping, the solution was heated to reflux for 6 hours, and the toluene solution was next separated. This toluene solution was iteratively washed using 300 g of water until the washed solution became neutral. The toluene solution was then heated in vacuo so that the toluene was distilled off, and 177.7 g of a white, solid hydrolysis/condensation product of phenyltrichlorosilane was obtained.

### [Preparation Example 1]

An amount of 155.5 g of the hydrolysis/condensation product of phenyltrichlorosilane prepared above, 80.5 g of 3-glycidoxypropyl methyl dimethoxysilane, 264 g of 2,4,6,8-tetramethyl-2,4,6,8-tetraphenyl cyclotetrasiloxane, 500 g of toluene, and 0.15 g of cesium hydroxide were put into a 1,000 ml flask equipped with a thermometer, a Dean-Stark pipe, and a reflux cooling pipe. An additional amount of 10.0 g of water was added. Water and methanol produced while heating this system were next distilled off, and heating and refluxing were further performed for 6 hours. After cooling, 0.08 g of acetic acid was put into this system to perform a neutralization treatment. The produced salt was next filtered, the filtrate was heated in vacuo, whereby the toluene was distilled off, and 475 g of a colorless, transparent liquid was obtained. This colorless, transparent liquid had a weight average molecular weight of 2,500, a glass transition point of -40°C, and an epoxy equivalent weight of 1,300, and was confirmed by ²⁹Si-nuclear magnetic resonance spectral analysis to be a 3-glycidoxypropyl group-containing siloxane compound expressed by the structural formula:

(PhMeSiO_{2/2})_{0.56}(EpMeSiO_{2/2})_{0.11}(PhSiO_{3/2})_{0.33}.

(the number of organic groups per silicon atom was 1.66, and the content of phenyl groups in the siloxane compound was 50% by weight). The content of hydroxyl groups or methoxy groups or other alkoxy groups was less than 1% by weight.

### [Preparation Example 2]

An amount of 103.2 g of the hydrolysis/condensation product of phenyltrichlorosilane prepared above, 81.3 g of 3-glycidoxypropyl methyl dimethoxysilane, 315.4 g of 2,4,6,8-tetramethyl-2,4,6,8-tetraphenyl cyclotetrasiloxane, 500 g of toluene, and 0.15 g of cesium hydroxide were put into a 1,000 ml flask equipped with a thermometer, a Dean-Stark pipe, and a reflux cooling pipe. An additional 10.0 g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 479 g of a colorless, transparent liquid was obtained. This colorless, transparent liquid had a weight average molecular weight of 2,500, a glass transition point of -45°C, and an epoxy equivalent weight of 1,300, and was confirmed by ²⁹Si-nuclear magnetic resonance spectral analysis to be a 3-glycidoxypropyl group-containing siloxane compound expressed by the structural formula:

(PhMeSiO_{2/2})_{0.62}(EpMeSiO_{2/2})_{0.11}(PhSiO_{3/2})_{0.27}.

(the number of organic groups per silicon atom was 1.73, and the content of phenyl groups in the siloxane compound was 49% by weight). The content of hydroxyl groups or methoxy groups or other alkoxy groups was less than 1% by weight.

### [Preparation Example 3]

An amount of 142.5 g of the hydrolysis/condensation product of phenyltrichlorosilane prepared above, 73.6 g of 3-glycidoxypropyl methyl dimethoxysilane, 217.7 g of diphenyl dimethoxysilane, 66.1 g of decamethyl cyclopentasiloxane, 500 g of toluene, and 0.15 g of cesium hydroxide were put into a 1,000 ml flask equipped with a thermometer, a Dean-Stark pipe, and a reflux cooling pipe. An additional 10.0 g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 460 g of a colorless, transparent liquid was obtained. This colorless, transparent liquid had a glass transition point of -65°C and an epoxy equivalent weight of 1,300, and was confirmed by ²⁹Si-nuclear magnetic resonance spectral analysis to be a 3-glycidoxypropyl group-containing siloxane compound expressed by the structural formula:

(Ph₂SiO_{2/2})_{0.28}(Me₂SiO_{2/2})_{0.28}(EpMeSiO_{2/2})_{0.11}(PhSiO_{3/2})_{0.33}

(the number of organic groups per silicon atom was 1.67, and the content of phenyl groups in the siloxane compound was 50% by weight). The content of hydroxyl groups or methoxy groups or other alkoxy groups was less than 1% by weight.

### [Preparation Example 4]

An amount of 122.2 g of the hydrolysis/condensation product of phenyltrichlorosilane prepared above, 69.0 g of 3-glycidoxypropyl methyl dimethoxysilane, 288.9 g of diphenyl dimethoxysilane, 19.7 g of decamethyl cyclopentasiloxane, 500 g of toluene, and 0.15 g of cesium hydroxide were put into a 1,000 ml flask equipped with a thermometer, a Dean-Stark pipe, and a reflux cooling pipe. An additional 10.0 g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 483 g of a colorless, transparent liquid was obtained. This colorless, transparent liquid had a glass transition point of -50°C and an epoxy equivalent weight of 1,300, and was confirmed by ²⁹Si-nuclear magnetic resonance spectral analysis to be a 3-glycidoxypropyl group-containing siloxane compound expressed by the structural formula:

(Ph₂SiO_{2/2})_{0.44}(Me₂SiO_{2/2})_{0.10}(EpMeSiO₂₂)_{0.12}(PhSiO_{3/2})_{0.34}

(the number of organic groups per silicon atom was 1.66, and the content of phenyl groups in the siloxane compound was 59% by weight). The content of hydroxyl groups or methoxy groups or other alkoxy groups was less than 1% by weight.

### [Preparation Example 5]

An amount of 185.2 g of the hydrolysis/condensation product of phenyltrichlorosilane prepared above, 109.2 g of 3-glycidoxypropyl methyl dimethoxysilane, 205.5 g of decamethyl cyclopentasiloxane, 500 g of toluene, and 0.15 g of cesium hydroxide were put into a 1,000 ml flask equipped with a thermometer, a Dean-Stark pipe, and a reflux cooling pipe. An additional 10.0g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 436 g of a colorless, transparent liquid was obtained. This colorless, transparent liquid had a weight average molecular weight of 1,800, a glass transition point of -67°C, and an epoxy equivalent weight of 1,000, and was confirmed by ²⁹Si-nuclear magnetic resonance spectral analysis to be a 3-glycidoxypropyl group-containing siloxane compound expressed by the structural formula:

(Me₂SiO_{2/2})_{0.60}(EpSiO_{3/2})_{0.10}(PhSiO_{3/2})_{0.30}

(the number of organic groups per silicon atom was 1.60, and the content of phenyl groups in the siloxane compound was 23% by weight). The content of hydroxyl groups or methoxy groups or other alkoxy groups was less than 1% by weight.

### [Preparation Example 6]

An amount of 323.6 g of the hydrolysis/condensation product of phenyltrichlorosilane prepared above, 80.0 g of 3-glycidoxypropyl methyl dimethoxysilane, 96.2 g of dodecamethyl pentasiloxane, 500 g of toluene, and 0.15 g of cesium hydroxide were put into a 1,000 ml flask equipped with a thermometer, a Dean-Stark pipe, and a reflux cooling pipe. An additional 10.0g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 451 g of a colorless, transparent liquid was obtained. This colorless, transparent liquid had a weight average molecular weight of 3,100, a glass transition point of -37°C, and an epoxy equivalent weight of 1,300, and was confirmed by ²⁹Si-nuclear magnetic resonance spectral analysis to be a 3-glycidoxypropyl group-containing siloxane compound expressed by the structural formula:

(Me₃SiO_{1/2})_{0.12}(Me₂SiO_{2/2})_{0.20}(EpMeSiO_{2/2})_{0.08}(PhSiO_{3/2})_{0.60}

(the number of organic groups per silicon atom was 1.52, and the content of phenyl groups in the siloxane compound was 40% by weight). The content of hydroxyl groups or methoxy groups or other alkoxy groups was less than 1% by weight.

### [Preparation Example 7]

An amount of 394 g of the hydrolysis/condensation product of phenyltrichlorosilane prepared above, 66.6 g of 3-glycidoxypropyl methyl dimethoxysilane, 39.2 g of decamethyl cyclopentasiloxane, 500 g of toluene, and 0.15 g of cesium hydroxide were put into a 1,000 ml flask equipped with a thermometer, a Dean-Stark pipe, and a reflux cooling pipe. An additional 10.0g of water was added. Water and methanol produced while heating this system were next distilled off, and heating and refluxing were further performed for 6 hours. After cooling, 0.08 g of acetic acid was put into this system to perform neutralization treatment. The produced salt was next filtered, and the filtrate was heated in vacuo, whereby the toluene was distilled off, and 475 g of a white solid was obtained. This white solid had a weight average molecular weight of 2,500, a glass transition point of 55°C, and an epoxy equivalent weight of 1,700, and was confirmed by ²⁹Si-nuclear magnetic resonance spectral analysis to be a 3-glycidoxypropyl group-containing siloxane compound expressed by the structural formula:

(Me₂SiO_{2/2})_{0.14}(EpMeSiO_{2/2})_{0.08}(PhSiO_{3/2})_{0.78}

(the number of organic groups per silicon atom was 1.22, and the content of phenyl groups in the siloxane compound was 48% by weight). The content of hydroxyl groups or methoxy groups or other alkoxy groups was less than 1% by weight.

### [Practical Example 1]

5 parts by weight of the siloxane compound prepared in Preparation Example 1 were added to 45 parts by weight of biphenylaralkyl epoxy resin (NC-3000 produced by Nippon Kayaku; epoxy equivalent weight = 275, softening point = 56°C), the ingredients were melted and mixed at 100°C, and the melt viscosity at 100°C was then measured. The melt viscosity was compared with the melt viscosity without the addition of the siloxane compound (1880 mPa·s); and at that time, cases in which the value was lower due to addition of the siloxane compound were determined to be "O" (favorable compatibility), and cases in which the value was raised were determined to be "X" (insufficient compatibility). Also, the presence or absence of separation from the epoxy resin was visually determined at 100°C. A small quantity of triphenyl phosphine was further added and stirred, the mixture was transferred to an aluminum dish and stored in an oven for 3 minutes at 175°C, and a cured material was obtained. The temperature of the obtained cured material was lowered to 25°C, a piece of paper was then pressed against the surface of the resin, and the presence or absence of transfer of the oil ingredient (oil exudation) was confirmed visually. The results are shown in Table 1.

### [Practical Example 2]

Practical Example 1 was repeated except that 5 parts by weight of the siloxane compound prepared in Preparation Example 2 were added instead of 5 parts by weight of the siloxane compound prepared in Preparation Example 1, and the evaluation was performed in the same manner as in Practical Example 1. The results are shown in Table 1.

### [Practical Example 3]

Practical Example 1 was repeated except that 5 parts by weight of the siloxane compound prepared in Preparation Example 3 were added instead of 5 parts by weight of the siloxane compound prepared in Preparation Example 1, and the evaluation was performed in the same manner as in Practical Example 1. The results are shown in Table 1.

### [Practical Example 4]

Practical Example 1 was repeated except that 5 parts by weight of the siloxane compound prepared in Preparation Example 4 were added instead of 5 parts by weight of the siloxane compound prepared in Preparation Example 1, and the evaluation was performed in the same manner as in Practical Example 1. The results are shown in Table 1.

### [Comparative Example 1]

Practical Example 1 was repeated except that 5 parts by weight of the siloxane compound prepared in Preparation Example 5 were added instead of 5 parts by weight of the siloxane compound prepared in Preparation Example 1, and the evaluation was performed in the same manner as in Practical Example 1. The results are shown in Table 1.

### [Comparative Example 2]

Practical Example 1 was repeated except that 5 parts by weight of the siloxane compound prepared in Preparation Example 6 were added instead of 5 parts by weight of the siloxane compound prepared in Preparation Example 1, and the evaluation was performed in the same manner as in Practical Example 1. The results are shown in Table 1.

### [Comparative Example 3]

Practical Example 1 was repeated except that SF8411 produced by Toray Dow Corning (epoxy modified silicone, Ph group content = 0% by weight, no branched structure) was used instead of 5 parts by weight of the siloxane compound prepared in Preparation Example 1, and the evaluation was performed in the same manner as in Practical Example 1. The results are shown in Table 1.

### [Comparative Example 4]

Practical Example 1 was repeated except that SF8421 produced by Toray Dow Corning (epoxy-polyether co-modified silicone, Ph group content = 0% by weight, no branched structure) was used instead of 5 parts by weight of the siloxane compound prepared in Preparation Example 1, and the evaluation was performed in the same manner as in Practical Example 1. The results are shown in Table 1.

### [Comparative Example 5]

Practical Example 1 was repeated except that 5 parts by weight of the siloxane compound prepared in Preparation Example 7 were added instead of 5 parts by weight of the siloxane compound prepared in Preparation Example 1, and the evaluation was performed in the same manner as in Practical Example 1. The results are shown in Table 1.

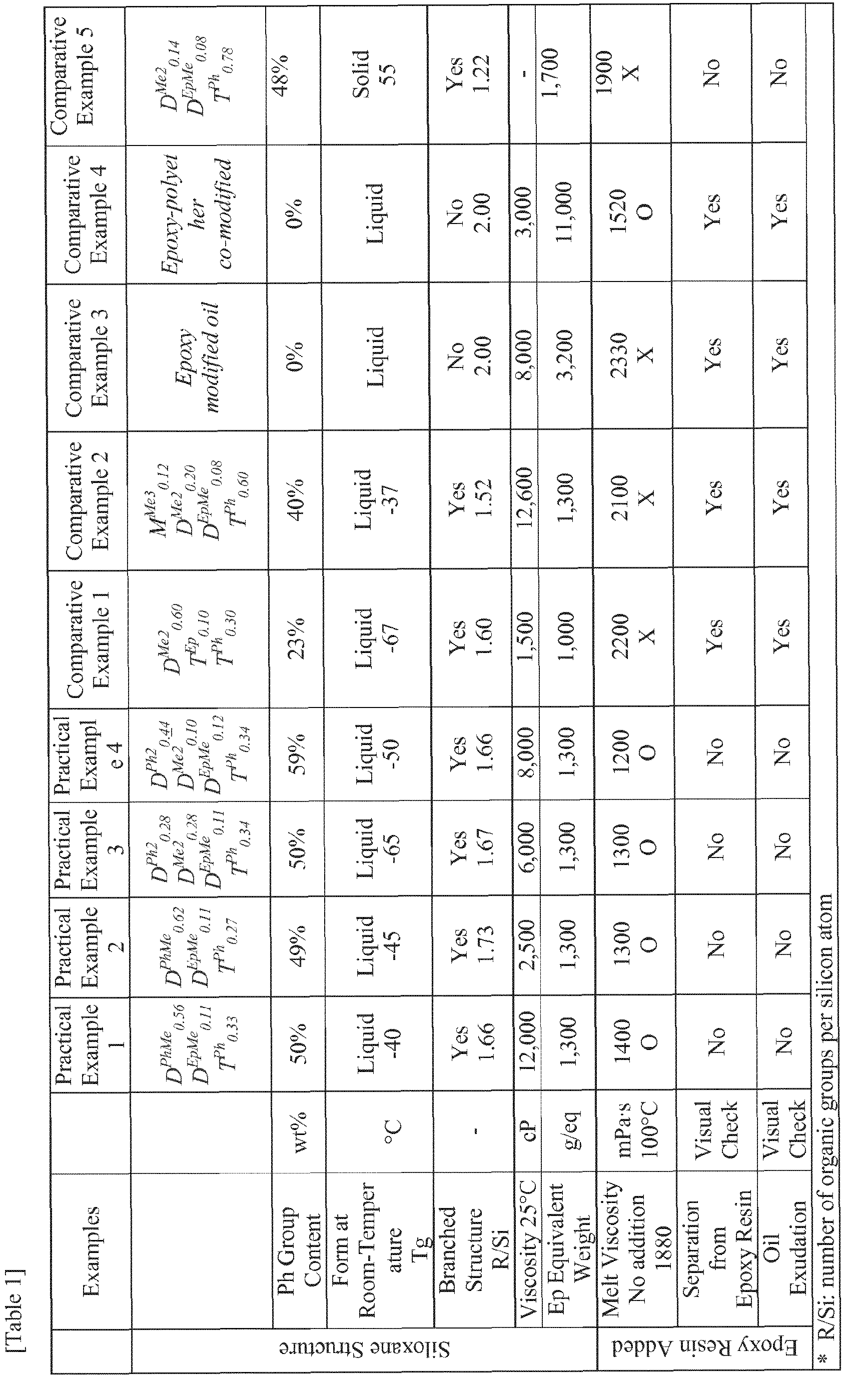

### [Practical Example 5]

An amount of 8.27 parts by weight of NC-3000 (biphenylaralkyl epoxy resin produced by Nippon Kayaku, epoxy equivalent weight = 275, softening point = 56°C), 5.51 parts by weight of MEH-7851SS (biphenylaralkyl phenolic resin produced by Meiwa Plastic Industries) as an epoxy resin curing agent, 85.45 parts by weight of FB-35X (spherical molten silica produced by Denki Kagaku Kogyo, mean particle size 14 µm), 0.14 parts by weight of triphenyl phosphine, 0.14 parts by weight of carnauba wax, and 0.5 parts by weight of the siloxane compound prepared in Preparation Example 1 were homogeneously melted and mixed by a hot double roll technique to prepare a curable epoxy resin composition. The charge parts are listed in Table 2. The results of evaluation of this curable epoxy resin composition and a cured material cured using the same are shown in Table 3.

### [Practical Example 6]

An amount of 8.06 parts by weight of NC-3000 (biphenylaralkyl epoxy resin produced by Nippon Kayaku, epoxy equivalent weight = 275, softening point = 56°C), 5.38 parts by weight of MEH-7851SS (biphenylaralkyl phenolic resin produced by Meiwa Plastic Industries) as an epoxy resin curing agent, 83.33 parts by weight of FB-35X (spherical molten silica produced by Denki Kagaku Kogyo, mean particle size 14 µm), 0.13 parts by weight of triphenyl phosphine, 0.13 parts by weight of carnauba wax, and 2.96 parts by weight of the siloxane compound prepared in Preparation Example 1 were homogeneously melted and mixed by a hot double roll technique to prepare a curable epoxy resin composition. The charge parts are listed in Table 2. The results of evaluation of this curable epoxy resin composition and a cured material cured using the same are shown in Table 3.

### [Practical Example 7]

Practical Example 5 was repeated except that the compound prepared in Preparation Example 2 was used instead of the siloxane compound prepared in Preparation Example 1, and the evaluation was performed in the same manner as in Practical Example 5.

### [Practical Example 8]

Practical Example 6 was repeated except that the compound prepared in Preparation Example 2 was used instead of the siloxane compound prepared in Preparation Example 1, and the evaluation was performed in the same manner as in Practical Example 6.

### [Reference Example 1]

Practical Example 5 was repeated except that the compound prepared in Preparation Example 7 was used instead of the siloxane compound prepared in Preparation Example 1, and the evaluation was performed in the same manner as in Practical Example 5.

### [Reference Example 2]

Practical Example 6 was repeated except that the compound prepared in Preparation Example 7 was used instead of the siloxane compound prepared in Preparation Example 1, and the evaluation was performed in the same manner as in Practical Example 6.

### [Reference Example 3] (System without the addition of a siloxane compound)

An amount of 8.31 parts by weight of NC-3000 (biphenylaralkyl epoxy resin produced by Nippon Kayaku, epoxy equivalent weight = 275, softening point = 60°C), 5.54 parts by weight of MEH-7851SS (biphenylaralkyl phenolic resin produced by Meiwa Plastic Industries) as an epoxy resin curing agent, 85.87 parts by weight of FB-35X (spherical molten silica produced by Denki Kagaku Kogyo, mean particle size 14 µm), 0.14 parts by weight of triphenyl phosphine, and 0.14 parts by weight of carnauba wax were homogeneously melted and mixed by a hot double roll technique to prepare a curable epoxy resin composition. The charge parts are listed in Table 2. The results of evaluation of this curable epoxy resin composition and a cured material cured using the same are shown in Table 3.

### [Reference Example 4]

Practical Example 5 was repeated except that the compound prepared in Preparation Example 6 was used instead of the siloxane compound prepared in Preparation Example 1, and the evaluation was performed in the same manner as in Practical Example 5.

**Table 2]**

| | Practical Example 5 Practical Example 7 Reference Example 1 Reference Example 4 | Practical Example 6 Practical Example 8 Reference Example 2 | Reference Example 3 |
|---|---|---|---|
| NC-3000 | 8.27 | 8.06 | 8.31 |
| MEH-7851SS | 5.51 | 5.38 | 5.54 |
| FB-35X | 85.45 | 83.33 | 85.87 |
| Triphenyl phosphine | 0.14 | 0.13 | 0.14 |
| Carnauba wax | 0.14 | 0.13 | 0.14 |
| Siloxane compound | 0.50 | 2.96 | 0 |
| Total | 100.0 | 100.0 | 100.0 |

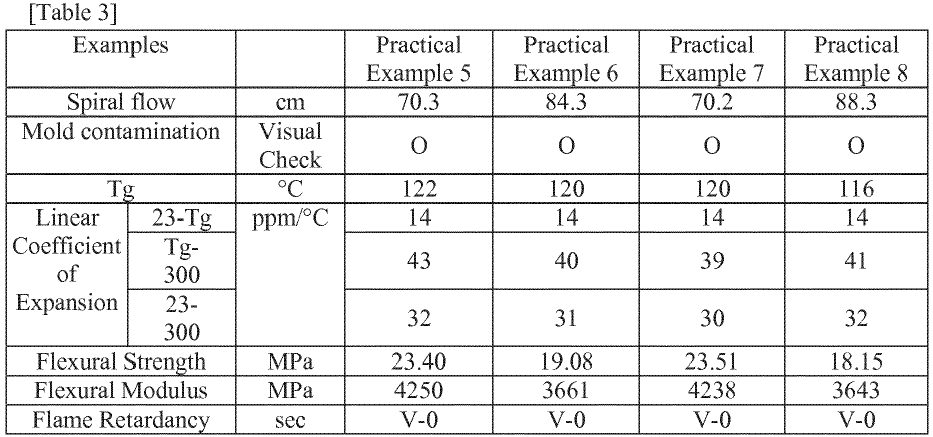

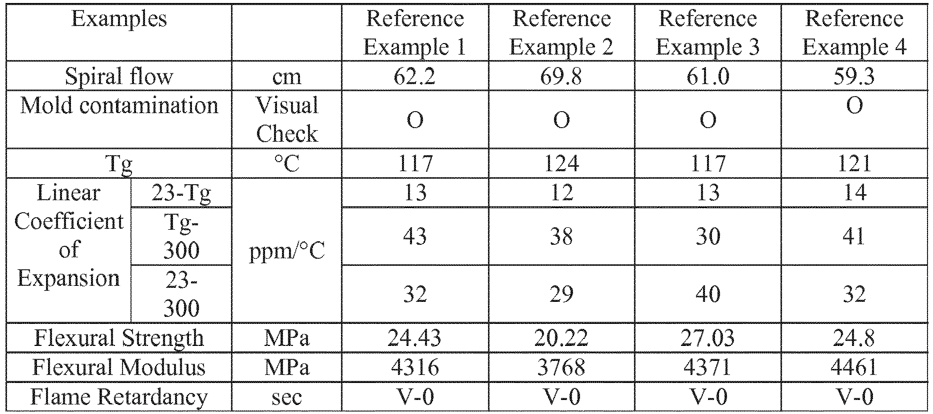

### [Practical Example A-1]

An amount of 22 parts by weight of the siloxane compound prepared in Preparation Example 1 was added to 60 parts by weight of biphenylaralkyl epoxy resin (NC-3000 produced by Nippon Kayaku; epoxy equivalent weight = 275, softening point = 56°C) and 40 parts by weight of biphenylaralkyl phenolic resin (MEH-7851SS produced by Meiwa Plastic Industries), the ingredients were melted and mixed at 100°C, and the melt viscosity at 100°C was then measured. When the melt viscosity was compared with the melt viscosity without the addition of the siloxane compound (2900 mPa·s), cases in which the value was lower due to addition of the siloxane compound were determined to be "O" (favorable compatibility), and cases in which the value was raised were determined to be "X" (insufficient compatibility). Also, the presence or absence of separation from the epoxy resin was visually determined at 100°C. A small quantity of triphenyl phosphine was further added and stirred, the mixture was transferred to an aluminum dish and stored in an oven for 3 minutes at 175°C, and a cured material was obtained; a piece of paper was then pressed against the surface of the resin, and the presence or absence of transfer of the oil ingredient (oil exudation) was confirmed visually.

### [Practical Example A-2]

Practical Example A-1 was repeated except that 5 parts by weight of the siloxane compound prepared in Preparation Example 2 were added instead of 5 parts by weight of the siloxane compound prepared in Preparation Example 1, and the evaluation was performed in the same manner as in Practical Example A-1. The results are shown in Table A.

### [Comparative Example A-1]

Practical Example A-1 was repeated except that 5 parts by weight of the siloxane compound prepared in Preparation Example 7 were added instead of 5 parts by weight of the siloxane compound prepared in Preparation Example 1, and the evaluation was performed in the same manner as in Practical Example A-1. The results are shown in Table A.

### [Comparative Example A-2]

Practical Example A-1 was repeated except that 5 parts by weight of the siloxane compound prepared in Preparation Example 6 were added instead of 5 parts by weight of the siloxane compound prepared in Preparation Example 1, and the evaluation was performed in the same manner as in Practical Example A-1. The results are shown in Table A.

### [Table 4]

**Table A**

| | | Practical Example A-1 | Practical Example A-2 | Comparative Example A-1 | Comparative Example A-2 |
|---|---|---|---|---|---|
| Melt Viscosity No addition 2900 | mPa·s | 1800 | 2100 | 3900 | 3300 |
| | 100°C | O | O | X | X |
| Separation from Epoxy Resin | Visual Check | No | No | No | Yes |
| Oil Exudation | Visual Check | No | No | No | Yes |

### [Practical Example B-1]

An amount of 10 parts by weight of the siloxane compound prepared in Preparation Example 1 was added to 47.4 parts by weight of biphenyl epoxy resin (YX-4000H produced by Mitsubishi Chemical; epoxy equivalent weight = 195, melting point = 106°C) and 42.6 parts by weight of phenolic aralkyl resin (Milex XLC-3L produced by Mitsui Chemical), the ingredients were melted and mixed at 120°C, and the melt viscosity at 100°C was then measured. When the melt viscosity was compared with the melt viscosity without the addition of the siloxane compound (1080 mPa·s), cases in which the value was 1000 or lower due to addition of the siloxane compound were determined to be "O" (favorable compatibility), and cases in which the value was raised were determined to "X" (insufficient compatibility). Also, the presence or absence of separation from the epoxy resin was visually determined at 100°C. A small quantity of triphenyl phosphine was further added and stirred, the mixture was transferred to an aluminum dish and stored in an oven for 3 minutes at 175°C, and a cured material was obtained; a piece of paper was then pressed against the surface of the resin, and the presence or absence of transfer of the oil ingredient (oil exudation) was confirmed visually. The results are shown in Table B.

### [Practical Example B-2]

Practical Example B-1 was repeated except that 10 parts by weight of the siloxane compound prepared in Preparation Example 2 were added instead of 10 parts by weight of the siloxane compound prepared in Preparation Example 1, and the evaluation was performed in the same manner as in Practical Example B-1. The results are shown in Table B.

### [Practical Example B-3]

Practical Example B-1 was repeated except that 10 parts by weight of the siloxane compound prepared in Preparation Example 3 were added instead of 10 parts by weight of the siloxane compound prepared in Preparation Example 1, and the evaluation was performed in the same manner as in Practical Example B-1. The results are shown in Table B.

### [Practical Example B-4]

Practical Example B-1 was repeated except that 10 parts by weight of the siloxane compound prepared in Preparation Example 4 were added instead of 10 parts by weight of the siloxane compound prepared in Preparation Example 1, and the evaluation was performed in the same manner as in Practical Example B-1. The results are shown in Table B.

### [Comparative Example B-1]

Practical Example B-1 was repeated except that 10 parts by weight of the siloxane compound prepared in Preparation Example 7 were added instead of 10 parts by weight of the siloxane compound prepared in Preparation Example 1, and the evaluation was performed in the same manner as in Practical Example B-1. The results are shown in Table B.

### [Comparative Example B-2]

Practical Example B-1 was repeated except that 10 parts by weight of the siloxane compound (LR-E-1300) prepared in Preparation Example 6 were added instead of 10 parts by weight of the siloxane compound prepared in Preparation Example 1, and the evaluation was performed in the same manner as in Practical Example B-1. The results are shown in Table B.

### [Comparative Example B-3]

Practical Example B-1 was repeated except that 10 parts by weight of SF8411 produced by Toray Dow Corning (epoxy modified silicone, Ph group content = 0% by weight, no branched structure) were added instead of 10 parts by weight of the siloxane compound prepared in Preparation Example 1, and the evaluation was performed in the same manner as in Practical Example B-1. The results are shown in Table B.

### [Comparative Example B-4]

Practical Example B-1 was repeated except that 10 parts by weight of SF8421 produced by Toray Dow Corning (epoxy-polyether co-modified silicone, Ph group content = 0% by weight, no branched structure) were added instead of 10 parts by weight of the siloxane compound prepared in Preparation Example 1, and the evaluation was performed in the same manner as in Practical Example B-1. The results are shown in Table B.

### [Comparative Example B-5]

Practical Example B-1 was repeated except that 10 parts by weight of SH200CV produced by Toray Down Corning (polydimethyl silicone, Ph-group content = 0% by weight, no branched structure) were added instead of 10 parts by weight of the siloxane compound prepared in Preparation Example 1, and the evaluation was performed in the same manner as in Practical Example B-1. The results are shown in Table B.
[Table 5]

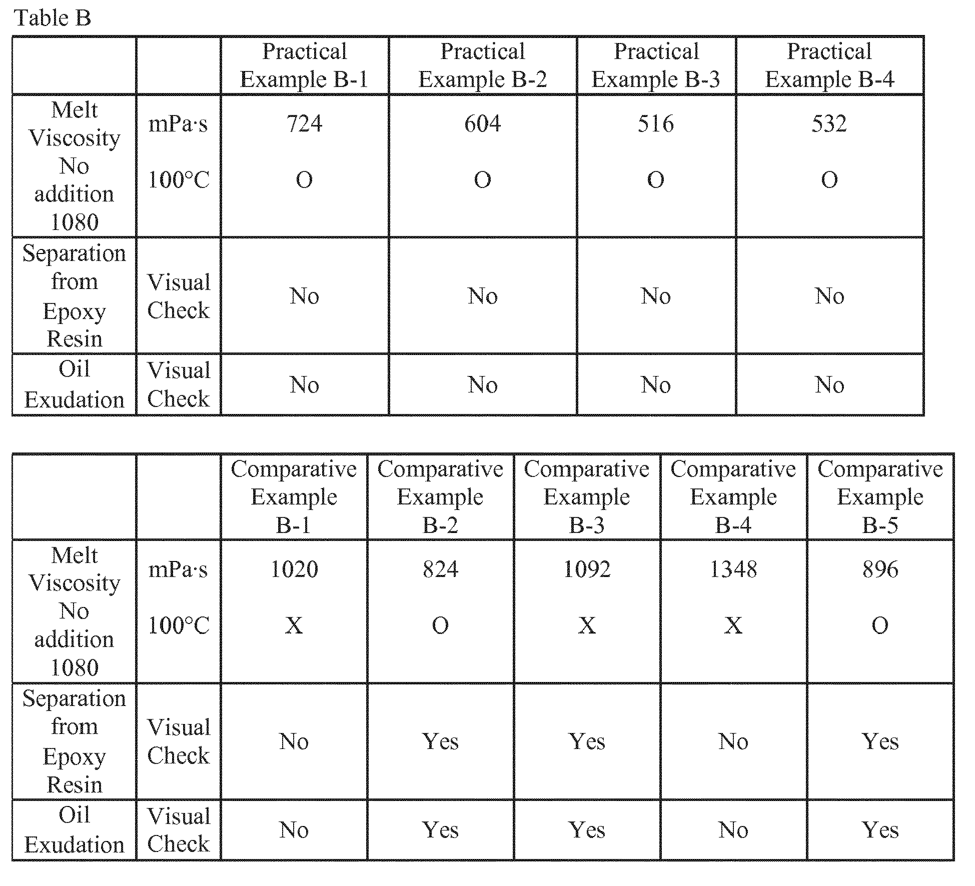

### [Practical Example C-1]

An amount of 7.34 parts by weight of YX-4000H (biphenyl epoxy resin produced by Mitsubishi Chemical; epoxy equivalent weight = 195, softening point = 106°C), 6.51 parts by weight of XLC-3L (phenolic aralkyl resin produced by Mitsui Chemical) as an epoxy resin curing agent, 85.81 parts by weight of FB-35X (spherical molten silica produced by Denki Kagaku Kogyo, mean particle size 14 µm), 0.14 parts by weight of triphenyl phospine, 0.14 parts by weight of carnauba wax, and 0.07 parts by weight of the siloxane compound prepared in Preparation Example 2 were homogeneously melted and mixed by a hot double roll technique to prepare a curable epoxy resin composition. The charge parts are listed in Table C-1. The results of evaluation of this curable epoxy resin composition and a cured material cured using the same are shown in Table C-2.

### [Reference Example C-1]

Practical Example C-1 was repeated except that the compound prepared in Preparation Example 7 was used instead of the siloxane compound prepared in Preparation Example 2, and the evaluation was performed in the same manner as in Practical Example C-1.

### [Reference Example C-2]

An amount of 7.34 parts by weight of YX-4000H (biphenyl epoxy resin produced by Mitsubishi Chemical; epoxy equivalent weight = 195, softening point = 106°C), 6.51 parts by weight of XLC-3L (phenolic aralkyl resin produced by Mitsui Chemical) as an epoxy resin curing agent, 85.81 parts by weight of FB-35X (spherical molten silica produced by Denki Kagaku Kogyo, mean particle size 14 µm), 0.14 parts by weight of triphenyl phospine, and 0.14 parts by weight of carnauba wax were homogeneously melted and mixed by a hot double roll technique to prepare a curable epoxy resin composition. The charge parts are listed in Table C-1. The results of evaluation of this curable epoxy resin composition and a cured material cured using the same are shown in Table C-2.

### [Table 6]

**Table C-1**

| | Practical Example C-1 Reference Example C-1 | Reference Example C-2 |
|---|---|---|
| YX-4000H | 7.34 | 7.34 |
| XLC-3L | 6.51 | 6.51 |
| FB-35X | 85.80 | 85.87 |
| Triphenyl phosphine | 0.14 | 0.14 |
| Carnauba wax | 0.14 | 0.14 |
| Siloxane compound | 0.07 | 0 |
| Total | 100.0 | 100.0 |

### [Table 7]

**Table C-2**

| | | | Practical Example C-1 | Reference Example C-1 | Reference Example C-2 |
|---|---|---|---|---|---|
| Spiral flow | | cm | 101.7 | 81.5 | 96.2 |
| Mold contamination | | Visual Check | O | O | O |
| Tg | | °C | 118 | 117 | 118 |
| Linear Coefficient of Expansion | 23-Tg | ppm/°C | 12 | 12 | 12 |
| | Tg-300 | | 38 | 39 | 42 |
| | 23-300 | | 29 | 30 | 32 |
| Flexural Strength | | MPa | 24.7 | 24.9 | 25.6 |
| Flexural Modulus | | MPa | 4517 | 4580 | 4583 |
| Flame Retardancy | | sec | V-1 | - | V-1 |

### [Practical Example D-1]

An amount of 10 parts by weight of the siloxane compound prepared in Preparation Example 1 was added to 90 parts by weight of phenol-novolac semisolid epoxy resin (jER154 produced by Mitsubishi Chemical; epoxy equivalent weight = 176), the ingredients were melted and mixed at 100°C, and the melt viscosity at 100°C was then measured. When the melt viscosity was compared with the melt viscosity without the addition of the siloxane compound (280 mPa·s), cases in which the value was lower due to addition of the siloxane compound were determined to be "O" (favorable compatibility), and cases in which the value was raised were determined to be "X" (insufficient compatibility). Also, the presence or absence of separation from the epoxy resin was visually determined at 100°C.

### [Practical Example D-2]

Practical Example D-1 was repeated except that 10 parts by weight of the siloxane compound prepared in Preparation Example 2 were added instead of 10 parts by weight of the siloxane compound prepared in Preparation Example 1, and the evaluation was performed in the same manner as in Practical Example D-1. The results are shown in Table D.

### [Practical Example D-3]

Practical Example D-1 was repeated except that 10 parts by weight of the siloxane compound prepared in Preparation Example 3 were added instead of 10 parts by weight of the siloxane compound prepared in Preparation Example 1, and the evaluation was performed in the same manner as in Practical Example D-1. The results are shown in Table D.

### [Comparative Example D-1]

Practical Example D-1 was repeated except that 10 parts by weight of the siloxane compound prepared in Preparation Example 7 were added instead of 10 parts by weight of the siloxane compound prepared in Preparation Example 1, and the evaluation was performed in the same manner as in Practical Example D-1. The results are shown in Table D.

### [Comparative Example D-2]

Practical Example D-1 was repeated except that 10 parts by weight of the siloxane compound prepared in Preparation Example 6 were added instead of 10 parts by weight of the siloxane compound prepared in Preparation Example 1, and the evaluation was performed in the same manner as in Practical Example D-1. The results are shown in Table D.

### [Table 8]

**Table D**

| | | Practical Example D-1 | Practical Example D-2 | Practical Example D-3 | Comparative Example D-1 | Comparative Example D-2 |
|---|---|---|---|---|---|---|
| Melt Viscosity No addition 280 | mPa·s | 268 | 252 | 196 | 328 | 320 |
| | 100°C | O | O | O | X | X |
| Separation from Epoxy Resin | Visual Check | No | No | No | No | Yes |

### [Practical Example E-1]

An amount of 10 parts by weight of the siloxane compound prepared in Preparation Example 1 was added to 90 parts by weight of a liquid bisphenol A epoxy resin (jER828 produced by Mitsubishi Chemical; epoxy equivalent weight = 185; viscosity at 25°C of 12000 mPa·s), the ingredients were melted and mixed at 100°C, and the viscosities at 25°C and 50°C were then measured. When the melt viscosity was compared with the melt viscosity without the addition of the siloxane compound (25°C: 12000 mPa·s, 50°C: 528 mPa·s), cases in which the value was lower due to addition of the siloxane compound were determined to be "O" (favorable compatibility), and cases in which the value was raised were determined to be "X" (insufficient compatibility). Also, the presence or absence of separation from the epoxy resin was visually determined at 100°C.

### [Practical Example E-2]

Practical Example E-1 was repeated except that 10 parts by weight of the siloxane compound prepared in Preparation Example 2 were added instead of 10 parts by weight of the siloxane compound prepared in Preparation Example 1, and the evaluation was performed in the same manner as in Practical Example E-1. The results are shown in Table E.

### [Practical Example E-3]

Practical Example E-1 was repeated except that 10 parts by weight of the siloxane compound prepared in Preparation Example 3 were added instead of 10 parts by weight of the siloxane compound prepared in Preparation Example 1, and the evaluation was performed in the same manner as in Practical Example E-1. The results are shown in Table E.

### [Comparative Example E-1]

Practical Example E-1 was repeated except that 10 parts by weight of the siloxane compound prepared in Preparation Example 7 were added instead of 10 parts by weight of the siloxane compound prepared in Preparation Example 1, and the evaluation was performed in the same manner as in Practical Example E-1. The results are shown in Table E.

### [Comparative Example E-2]

Practical Example E-1 was repeated except that 10 parts by weight of the siloxane compound prepared in Preparation Example 6 were added instead of 10 parts by weight of the siloxane compound prepared in Preparation Example 1, and the evaluation was performed in the same manner as in Practical Example E-1. The results are shown in Table E.

### [Table 9]

**Table E**

| | | Practical Example E-1 | Practical Example E-2 | Practical Example E-3 | Comparative Example E-1 | Comparative Example E-2 |
|---|---|---|---|---|---|---|
| Visual appearance | Visual Check | Transparent | Transparent | Transparent | Slightly Cloudy | Cloudy |
| Viscosity No addition 12000 | mPa·s | 10200 | 9400 | 8900 | 17100 | 14200 |
| | 25°C | O | O | O | X | X |
| Viscosity No addition 528 | mPa·s | 516 | 488 | 404 | 728 | 564 |
| | 50°C | O | O | O | X | X |
| Separation from Epoxy Resin | Visual Check | No | No | No | No | Yes |

### [Practical Example F-1]

An amount of 2 parts by weight of the siloxane compound prepared in Preparation Example 1, 10.0 parts by weight of a liquid epoxy resin (Ceroxide 2021P produced by Daicel Chemical Industries, viscosity of 242 mPa·s (25°C); epoxy equivalent weight = 130), 6.7 parts by weight of a liquid acid anhydride (HN5500E: 3- or 4-methyl-hexahydrophthalic acid anhydride produced by Hitachi Chemical, 61 mPa·s (25°C)), and 0.1 parts by weight of diazabicycloundecene were mixed at room temperature, and a curable liquid epoxy composition was prepared. The viscosity was measured by a type-E viscometer (EMD viscometer produced by Tokimec, 10 rpm rotation). An amount of 6 parts by weight of the composition was placed in a 5 cm-diameter aluminum plate, heated for 2 hours at 150°C, then removed, and the visual appearance was examined. The results are shown in Table F.

### [Practical Example F-2]

An amount of 2 parts by weight of the siloxane compound prepared in Preparation Example 2, 10.0 parts by weight of a liquid epoxy resin (Ceroxide 2021P produced by Daicel Chemical Industries, viscosity of 242 mPa·s (25°C); epoxy equivalent weight = 130), 6.7 parts by weight of a liquid acid anhydride (HN5500E produced by Hitachi Chemical, 61 mPa·s (25°C)), and 0.1 parts by weight of diazabicycloundecene were mixed at room temperature, and a curable liquid epoxy composition was prepared. The viscosity was measured by a type-E viscometer (EMD viscometer produced by Tokimec, 10 rpm rotation). An amount of 6 parts by weight of the composition was placed in a 5 cm-diameter aluminum plate, heated for 2 hours at 150°C, then removed, and the visual appearance was examined. The results are shown in Table F.

### ]Comparative Example F-1]

The same procedure as in Practical Example F-1 was carried out except that the siloxane compound of Practical Example A prepared in Preparation Example 1 was not mixed in. The properties were evaluated in the same manner as in Practical Example F-1, and the results are shown in Table F.

### [Comparative Example F-2]

An amount of 2 parts by weight of the siloxane compound prepared in Preparation Example 7, 10.0 parts by weight of a liquid epoxy resin (Ceroxide 2021P produced by Daicel Chemical Industries, viscosity of 242 mPa·s (25°C); epoxy equivalent weight = 130), 6.7 parts by weight of a liquid acid anhydride (HN5500E produced by Hitachi Chemical, 61 mPa·s (25°C)), and 0.1 parts by weight of diazabicycloundecene were mixed at room temperature, and a curable liquid epoxy composition was prepared. The viscosity was measured by a type-E viscometer (EMD viscometer produced by Tokimec, 10 rpm rotation). An amount of 6 parts by weight of the composition was placed in a 5 cm-diameter aluminum plate, heated for 2 hours at 150°C, then removed, and the visual appearance was examined. The results are shown in Table F.

### [Table 10]

**Table F**

| | Viscosity before curing (mPa·s) | Visual appearance after curing |
|---|---|---|
| Practical Example F-1 | 219 | No cracks |
| Practical Example F-2 | 192 | No cracks |
| Comparative Example F-1 | 183 | Large cracks present |
| Comparative Example F-2 | 237 | No cracks |

## Claims

1. A curable epoxy resin composition comprising:
(I) a curable epoxy resin; and
(II) an epoxy functional group- and aromatic hydrocarbon group-containing organopolysiloxane having an epoxy equivalent weight of 3,000 or lower, measured by titration method following JIS K 7236, a content of aromatic hydrocarbon groups of 45 to 80% by weight (mass), and a glass transition point of less than 0°C, measured by DSC as described in the description.

2. The curable epoxy resin composition according to claim 1, wherein a proportion of epoxy functional groups among organic groups bound to silicon atoms in a molecule of the organopolysiloxane is 0.1 to 40 mol%.

3. The curable epoxy resin composition according to claim 1 or 2, wherein a proportion of aromatic hydrocarbon groups among organic groups bound to silicon atoms in a molecule of the organopolysiloxane is 40 mol% or higher.

4. The curable epoxy resin composition according to any of claims 1 to 3, wherein the ingredient (II) is a branched organopolysiloxane expressed by the following average unit formula:
(R¹R²R³SiO_{1/2})ₐ(R⁴R⁵SiO_{2/2})_{b}(R⁶SiO_{3/2})_{c} (1)
(wherein:
R¹, R², R³, R⁴, R⁵, and R⁶ respectively and independently represent a monovalent hydrocarbon group or epoxy functional group, where at least one of R¹, R², R³, R⁴, R⁵, and R⁶ is an epoxy functional group, at least one of R¹, R², R³, R⁴, R⁵, and R⁶ is a monovalent aromatic hydrocarbon group; and
"a" is 0 to 0.2, "b" is a positive number, "c" is a positive number of 0.1 or higher, a + b + c = 1, and "3a + 2b + c" is in a range of 1.5 to 2.2).

5. The curable epoxy resin composition according to any of claims 1 to 4, wherein the weight average molecular weight of the ingredient (II) is 1,000 to 10,000, obtained through standard polystyrene conversion using gel permeation chromatography.

6. The curable epoxy resin composition according to any of claims 1 to 5, wherein the ingredient (I) is a biphenyl group-containing epoxy resin.

7. The curable epoxy resin composition according to any of claims 1 to 6, wherein the curable epoxy resin composition further comprises (III) an epoxy resin curing agent, preferably a phenolic hydroxyl group-containing compound, and more preferably a biphenyl group-containing phenolic resin.

8. The curable epoxy resin composition according to claim 7, wherein the content of the ingredient (III) is a quantity such that the epoxy reactive functional groups in the ingredient (III) are 0.5 to 2.5 moles per mole of epoxy functional groups in the ingredient (I).

9. The curable epoxy resin composition according to any of claims 1 to 8, wherein the content of the ingredient (II) is 0.1 to 100 parts by weight per 100 parts by weight of the ingredient (I) or of the total of the ingredients (I) and (III).

10. The curable epoxy resin composition according to any of claims 1 to 9, wherein the curable epoxy resin composition further comprises (IV) an inorganic filler, preferably a spherical inorganic filler, and more preferably spherical amorphous silica.

11. The curable epoxy resin composition according to claim 10, wherein the content of the ingredient (IV) is at least 20% by weight based on the total weight of the composition.

12. The curable epoxy resin composition according to any of claims 7 to 11, wherein the curable epoxy resin composition further comprises (V) an epoxy resin curing accelerator.

13. The curable epoxy resin composition according to claim 12, wherein the content of the ingredient (V) is 0.001 to 20 parts by weight per 100 parts by weight of the ingredient (I).

14. The curable epoxy resin composition according to any of claims 1 to 13, wherein the curable epoxy resin composition is a semiconductor sealant.

15. A cured material cured using the curable epoxy resin composition according to any of claims 1 to 14.

## Patentansprüche

1. Eine härtbare Epoxidharzzusammensetzung, beinhaltend:
(I) ein härtbares Epoxidharz; und
(II) ein funktionelle Epoxidgruppen und aromatische Kohlenwasserstoffgruppen enthaltendes Organopolysiloxan mit einem Epoxidäquivalentgewicht von 3000 oder weniger, gemessen durch ein Titrationsverfahren nach JIS K 7236, einem Gehalt an aromatischen Kohlenwasserstoffgruppen von 45 bis 80 Gew.-% (Masse) und einem Glasumwandlungspunkt von weniger als 0 °C, gemessen durch DSC wie in der Beschreibung beschrieben.

2. Härtbare Epoxidharzzusammensetzung gemäß Anspruch 1, wobei ein Teil der funktionellen Epoxidharzgruppen unter organischen Gruppen, gebunden an Siliciumatome in einem Molekül des Organopolysiloxans, 0,1 bis 40 Mol-% beträgt.

3. Härtbare Epoxidharzzusammensetzung gemäß Anspruch 1 oder 2, wobei ein Teil der aromatischen Kohlenwasserstoffgruppen unter organischen Gruppen, gebunden an Siliciumatome in einem Molekül des Organopolysiloxans, 40 Mol-% oder mehr beträgt.

4. Härtbare Epoxidharzzusammensetzung gemäß einem der Ansprüche 1 bis 3, wobei der Inhaltsstoff (II) ein verzweigtes Organopolysiloxan ist, ausgedrückt durch die folgende Durchschnittsein heitsformel:
(R¹R²R³SiO_{1/2})ₐ(R⁴R⁵SiO_{2/2})_{b}(R⁶SiO_{3/2})_{c} (1)
(wobei:
R¹, R², R³, R⁴, R⁵ und R⁶ jeweils und unabhängig eine monovalente Kohlenwasserstoffgruppe oder funktionelle Epoxidharzgruppe darstellen, wobei mindestens eines von R¹, R², R³, R⁴, R⁵ und R⁶ eine funktionelle Epoxidharzgruppe ist, mindestens eines von R¹, R², R³, R⁴, R⁵ und R⁶ eine monovalente aromatische Kohlenwasserstoffgruppe ist; und "a" 0 bis 0,2 ist, "b" eine positive Zahl ist, "c" eine positive Zahl von 0,1 oder mehr ist, a + b + c = 1 und "3a + 2b + c" in einem Bereich von 1,5 bis 2,2 liegt).

5. Härtbare Epoxidharzzusammensetzung gemäß einem der Ansprüche 1 bis 4, wobei das Gewichtsmittel des Molekulargewichts des Inhaltsstoffs (II) 1000 bis 10000 beträgt, erhalten durch Standardpolystyrolumwandlung unter Verwendung von Gelpermeationschromatographie.

6. Härtbare Epoxidharzzusammensetzung gemäß einem der Ansprüche 1 bis 5, wobei der Inhaltsstoff (I) ein Biphenylgruppe enthaltendes Epoxidharz ist.

7. Härtbare Epoxidharzzusammensetzung gemäß einem der Ansprüche 1 bis 6, wobei die härtbare Epoxidharzzusammensetzung ferner (III) ein Epoxidharzhärtungsmittel, vorzugsweise eine eine phenolische Hydroxylgruppe enthaltende Verbindung und noch besser ein eine Biphenylgruppe enthaltendes Phenolharz beinhaltet.

8. Härtbare Epoxidharzzusammensetzung gemäß Anspruch 7, wobei der Gehalt des Inhaltsstoffs (III) eine derartige Menge ist, dass die epoxidreaktiven funktionellen Gruppen in dem Inhaltsstoff (III) 0,5 bis 2,5 Mol pro Mol der funktionellen Epoxidgruppen in dem Inhaltsstoff (I) betragen.

9. Härtbare Epoxidharzzusammensetzung gemäß einem der Ansprüche 1 bis 8, wobei der Gehalt des Inhaltsstoffs (II) 0,1 bis 100 Gewichtsteile pro 100 Gewichtsteile des Inhaltsstoffs (I) oder der Gesamtheit der Inhaltsstoffe (I) und (III) beträgt.

10. Härtbare Epoxidharzzusammensetzung gemäß einem der Ansprüche 1 bis 9, wobei die härtbare Epoxidharzzusammensetzung ferner (IV) einen anorganischen Füllstoff, vorzugsweise einen kugelförmigen anorganischen Füllstoff und noch besser kugelförmige amorphe Kieselsäure beinhaltet.

11. Härtbare Epoxidharzzusammensetzung gemäß Anspruch 10, wobei der Gehalt des Inhaltsstoffs (IV) bezogen auf das Gesamtgewicht der Zusammensetzung mindestens 20 Gew.-% beträgt.

12. Härtbare Epoxidharzzusammensetzung gemäß einem der Ansprüche 7 bis 11, wobei die härtbare Epoxidharzzusammensetzung ferner (V) einen Beschleuniger der Härtung des Epoxidharzes beinhaltet.

13. Härtbare Epoxidharzzusammensetzung gemäß Anspruch 12, wobei der Gehalt des Inhaltsstoffs (V) 0,001 bis 20 Gewichtsteile pro 100 Gewichtsteile des Inhaltsstoffs (I) beträgt.

14. Härtbare Epoxidharzzusammensetzung gemäß einem der Ansprüche 1 bis 13, wobei die härtbare Epoxidharzzusammensetzung ein Halbleiterdichtungsmittel ist.

15. Ein ausgehärtetes Material, gehärtet unter Verwendung der härtbaren Epoxidharzzusammensetzung gemäß einem der Ansprüche 1 bis 14.

## Revendications

1. Une composition de résine époxy durcissable comprenant :
(I) une résine époxy durcissable ; et
(II) un organopolysiloxane contenant des groupes fonctionnels époxy et des groupes hydrocarbonés aromatiques ayant un poids équivalent d'époxy de 3 000 ou moins, mesuré par une méthode de titrage suivant la JIS K 7236, une teneur en groupes hydrocarbonés aromatiques de 45 à 80 % en poids (masse), et un point de transition vitreuse inférieur à 0 °C, mesuré par une ACD tel que décrit dans la description.

2. La composition de résine époxy durcissable selon la revendication 1, dans laquelle une proportion de groupes fonctionnels époxy parmi des groupes organiques liés à des atomes de silicium dans une molécule de l'organopolysiloxane va de 0,1 à 40 % en moles.

3. La composition de résine époxy durcissable selon la revendication 1 ou la revendication 2, dans laquelle une proportion de groupes hydrocarbonés aromatiques parmi des groupes organiques liés à des atomes de silicium dans une molécule de l'organopolysiloxane est de 40 % en moles ou plus.

4. La composition de résine époxy durcissable selon n'importe lesquelles des revendications 1 à 3, dans laquelle l'ingrédient (II) est un organopolysiloxane ramifié exprimé par la formule unitaire moyenne suivante :
(R¹R²R³SiO_{1/2})ₐ(R⁴R⁵SiO_{2/2})_{b}(R⁶SiO_{3/2})_{c} (1)
(dans laquelle :
R¹, R², R³, R⁴, R⁵, et R⁶ représentent respectivement et indépendamment un groupe hydrocarboné monovalent ou un groupe fonctionnel époxy, où au moins un R parmi R¹, R², R³, R⁴, R⁵, et R⁶ est un groupe fonctionnel époxy, au moins un R parmi R¹, R², R³, R⁴, R⁵, et R⁶ est un groupe hydrocarboné aromatique monovalent ; et « a » va de 0 à 0,2, « b » est un nombre positif, « c » est un nombre positif de 0,1 ou plus, a + b + c = 1, et « 3a + 2b + c » est compris dans une gamme allant de 1,5 à 2,2).

5. La composition de résine époxy durcissable selon n'importe lesquelles des revendications 1 à 4, dans laquelle la masse moléculaire moyenne en poids de l'ingrédient (II) va de 1 000 à 10 000, obtenue par conversion de polystyrène de référence à l'aide d'une chromatographie par perméation sur gel.

6. La composition de résine époxy durcissable selon n'importe lesquelles des revendications 1 à 5, dans laquelle l'ingrédient (I) est une résine époxy contenant un groupe diphényle.

7. La composition de résine époxy durcissable selon n'importe lesquelles des revendications 1 à 6, la composition de résine époxy durcissable comprenant en sus (III) un agent de durcissement de résine époxy, préférablement un composé contenant des groupes hydroxyles phénoliques, et plus préférablement une résine phénolique contenant un groupe diphényle.

8. La composition de résine époxy durcissable selon la revendication 7, dans laquelle la teneur en ingrédient (III) est une quantité telle que les groupes fonctionnels réactifs à l'époxy dans l'ingrédient (III) représentent de 0,5 à 2,5 moles par mole de groupes fonctionnels époxy dans l'ingrédient (I).

9. La composition de résine époxy durcissable selon n'importe lesquelles des revendications 1 à 8, dans laquelle la teneur en ingrédient (II) va de 0,1 à 100 parties en poids pour 100 parties en poids de l'ingrédient (I) ou du total des ingrédients (I) et (III).

10. La composition de résine époxy durcissable selon n'importe lesquelles des revendications 1 à 9, la composition de résine époxy durcissable comprenant en sus (IV) une charge inorganique, préférablement une charge inorganique sphérique, et plus préférablement de la silice amorphe sphérique.

11. La composition de résine époxy durcissable selon la revendication 10, dans laquelle la teneur en ingrédient (IV) est d'au moins 20 % en poids rapporté au poids total de la composition.

12. La composition de résine époxy durcissable selon n'importe lesquelles des revendications 7 à 11, la composition de résine époxy durcissable comprenant en sus (V) un accélérateur de durcissement de résine époxy.

13. La composition de résine époxy durcissable selon la revendication 12, dans laquelle la teneur en ingrédient (V) va de 0,001 à 20 parties en poids pour 100 parties en poids de l'ingrédient (I).

14. La composition de résine époxy durcissable selon n'importe lesquelles des revendications 1 à 13, la composition de résine époxy durcissable étant un produit d'étanchéité semi-conducteur.

15. Un matériau durci, durci à l'aide de la composition de résine époxy durcissable selon n'importe lesquelles des revendications 1 à 14.
